# EUROPEAN PATENT SPECIFICATION

(11) **EP 3 784 010 B1**
(45) Date of publication and mention of the grant of the patent: **05.11.2025**
(21) Application number: 20192032.9
(22) Date of filing: 20.08.2020
(51) Int. Cl.: H05K 7/14

(54) **QUICK EXCHANGE DOCKING CONNECTOR**
SCHNELL AUSTAUSCHBARER ANDOCKANSCHLUSS
CONNECTEUR D'ACCUEIL À ÉCHANGE RAPIDE

(30) Priority: 20.08.2019 US 201962889527 P
(43) Date of publication of application: 24.02.2021
(73) Proprietor: Virginia Panel Corporation, Waynesboro VA 22980-1338 (US)
(72) Inventor: Shepard, Adam Peter, Waynesboro, Virginia (US); Ashby, Darryl M., Waynesboro, Virginia (US)
(74) Representative: Sonnenberg Harrison Partnerschaft mbB

(56) References cited:
- US-A- 4 583 808
- US-A1- 2002 137 389
- US-A1- 2015 087 175
- US-A1- 2016 056 567
- US-A1- 2018 358 735

## Description

### CROSS-REFERENCE TO RELATED APPLICATIONS

The present application claims priority of U.S. Provisional Patent Application Serial No. 62/889,527 filed on August 20, 2019.

### BACKGROUND OF THE INVENTION

### Field Of The Invention

The present invention relates to a docking connector for holding modules for connector pins.

### Brief Description Of The Related Art

A variety of electrical interface devices exist for housing modules that hold electrical and/or pneumatic contacts of various types. Examples of such interface devices are disclosed in U.S. Patent No. 7,091,415, U.S. Patent No. 7,297,014, U.S. Patent No. 8,348,693, and U.S. Patent No. 9,257,787. These various types of interface devices each have a receiver side and a test adapter side where the receiver side is connected to or mounted on test equipment and the test adapter side is connected to a unit under test. When the test adapter, known as an "ITA," is mated to the receiver, a plurality of contact can be connected to each other in a stable and safe manner to minimize or eliminate damage to the contact during mating. The interface devices come in a wide variety of sizes that can hold small number of contacts or very large numbers of contacts.

The receiver and test adapter in an interface device typically each have a frame that holds a plurality of modules. The different types of interface devices often have modules of different dimensions such that modules from one interface type cannot be used in a different interface type. To overcome this problem, U.S. Patent No. 8,351,218 discloses an interface device having multiple tiers such that modules of a first size can be mounted in the receiver or test adapter in one tier and modules of a second size can be mounted in the receiver or test adapter in a second tier. In this manner, modules of different sizes can be used simultaneously in the same interface device.

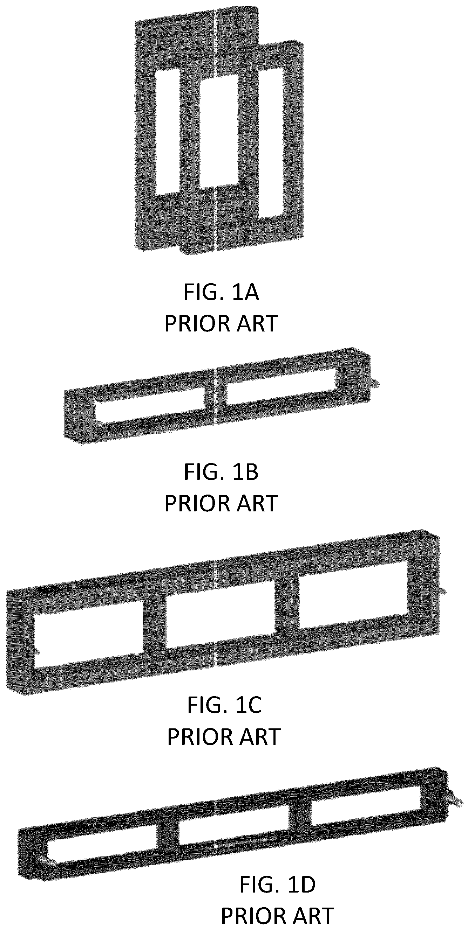

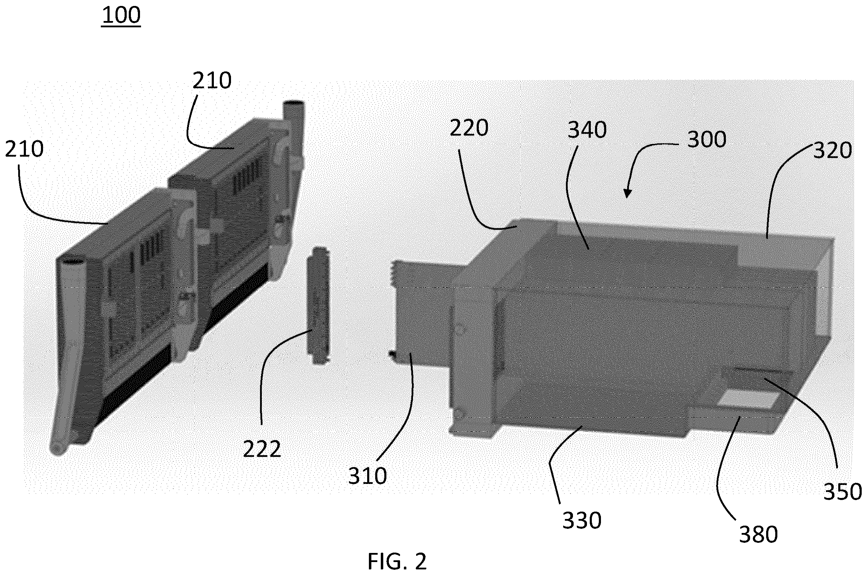

In small applications an engagement mechanism may not be necessary so a frame, referred to herein as a "docking connector," is used to hold connector modules filled with connector pins to improve connection times. Exemplary prior docking connectors are shown in FIGs. 1A-1D and 2. Each of these prior docking connectors has two pairs of opposing sides to form a rectangular or square frame. As shown in the example in FIG. 1A, one pair of opposing sides, the top and bottom in FIG. 1A, has holes or other means for connecting a plurality of modules to the frame in a side-by-side manner. In other examples such as are shown in FIGs. 1B-1D, the frame includes intermediate members having holes or other means for connecting modules between the intermediate members and a side or between two intermediate members. Additionally, U.S. Published Patent Application No. 2018/0358735 discloses a configurable docking connector in which modules of differing sizes may be used.

The US Patent Application No US 2016/0056567 A1 teaches a docking connector according to the preamble of claim 1.

### SUMMARY OF THE INVENTION

The present invention proposes a docking connector according to claim 1.

Still other aspects, features, and advantages of the present invention are readily apparent from the following detailed description, simply by illustrating a preferable embodiments and implementations. The present invention is also capable of other and different embodiments and its several details can be modified in various obvious respects, provided that said modifications fall within the scope of the present invention, which is defined by the appended claims. Accordingly, the drawings and descriptions are to be regarded as illustrative in nature, and not as restrictive. Additional objects and advantages of the invention will be set forth in part in the description which follows and in part will be obvious from the description or may be learned by practice of the invention.

### BRIEF DESCRIPTION OF THE DRAWINGS

For a more complete understanding of the present invention and the advantages thereof, reference is now made to the following description and the accompanying drawings, in which:
FIGs. 1A-1D are perspective view of prior art docking connectors.
FIG. 2 is perspective assembly view of an interface system employing a secondary docking connector.
FIG. 3 is a side perspective view of PCB's in an enclosure or fixture having a secondary docking connector.

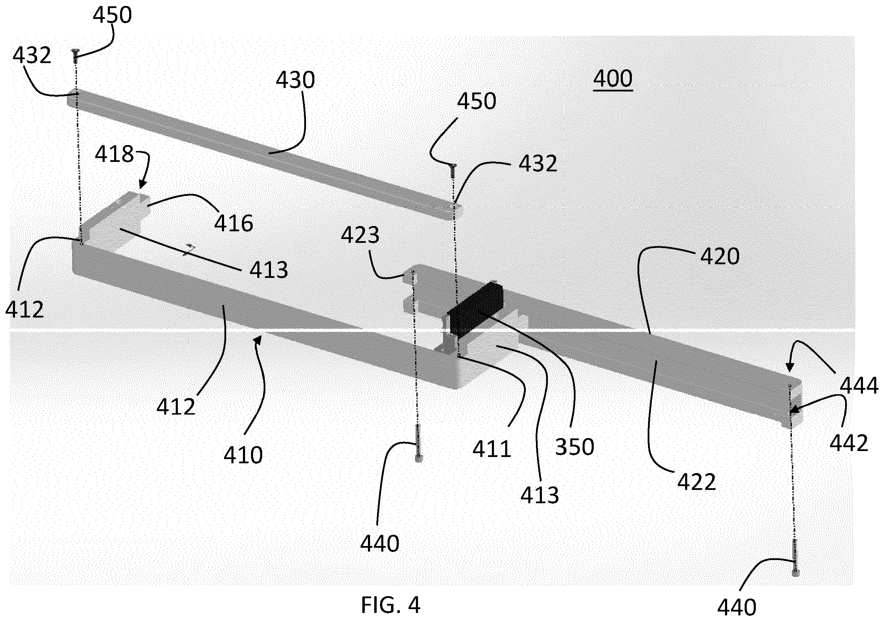

FIG. 4 is a perspective view of a quick exchange docking connector in accordance with a preferred embodiment of the present invention.
FIG. 5 is a side perspective view of a quick exchange docking connector in accordance with a preferred embodiment of the present invention with a module and PCB.

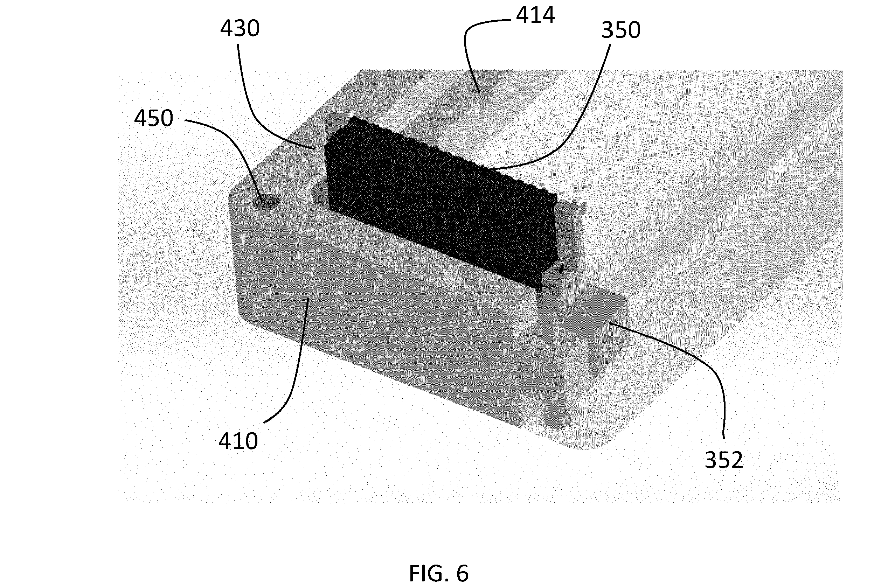

FIG. 6 is a partial close-up perspective view of a quick exchange docking connector in accordance with a preferred embodiment of the present invention with a module. The bottom bar of the docking connector is transparent to provide a view of the module in the docking connector.

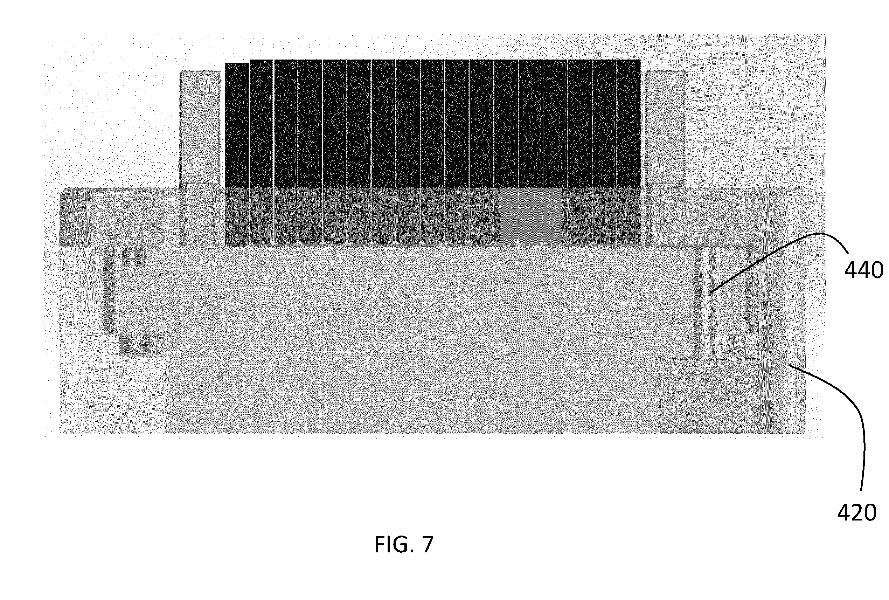

FIG. 7 is a side view of a quick exchange docking connector in accordance with a preferred embodiment of the present invention with a module. The top bar of the docking connector is transparent to provide a view of the module in the docking connector.

### DETAILED DESCRIPTION OF THE PREFERRED EMBODIMENTS

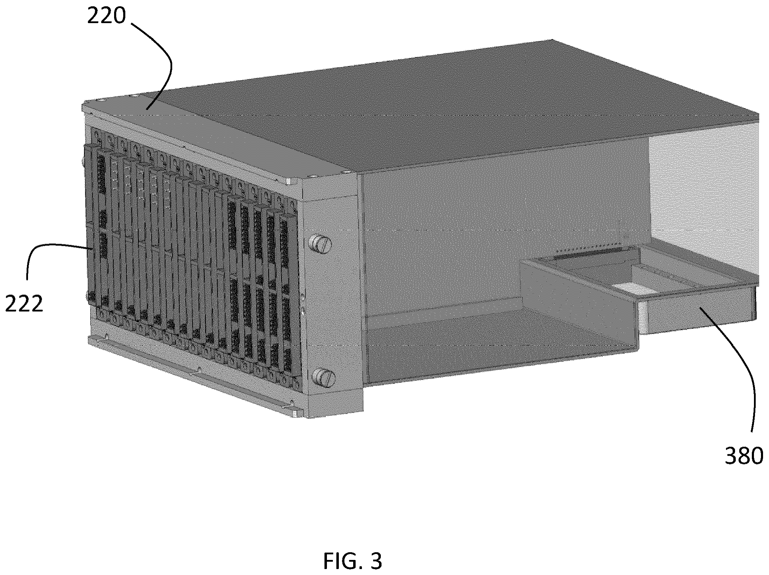

An application for a docking connector in accordance with the present invention may be referred to as a "secondary docking connector." An example of such a system employing a "secondary docking connector" is shown in FIG. 3. The interface system 100 has a plurality of printed circuit boards (PCB's) 310 mounted in a fixture 300. The system has a standard interface comprising a receiver or receivers 210 mounted to test equipment (not shown) and a fixture or enclosure 300 having one or more interchangeable test adapters (ITA) 220 that each mate with the receiver 210. The test adapter 220 has a first plurality of modules 222 mounted in the test adapter 220, a plurality of PCB's 310 each having a first end connected to the first plurality of modules 222 and a secondary docking connector 380 having a second plurality of modules 350 connected to second ends of the plurality of PCB's. The modules 222 typically are each mounted to the test adapter frame with a screw at each end of the module. The enclosure or fixture 300 further has a cover 320 and supporting structure 330, 340.

In FIG. 2, one of the PCB's 310 is shown in a position in which it appears to have been pulled out through the front of the text adapter 220. With a conventional docking connector, however, even if the screws mounting the module 222 are removed and the module is removed the PCB 310 cannot be removed through the face of the test adapter 220 because movement of the second plurality of modules 350 in that direction is blocked by the secondary docking connector 380. The present invention solves this shortcoming by providing a "quick exchange" docking connector that allows the bottom bar of the docking connector to be quickly removed to allow the PCB's to slide directly out of the face of the test adapter 220. The term "bottom bar" here is used to refer to the side of the docking connector frame that is closest to the test adapter 220. The opposing side of the docking connector that is furthest form the test adapter 220 is referred to herein at the "top bar."

A quick exchange docking connector in accordance with a preferred embodiment of the present invention is described with reference to FIG.s 4-7. The quick exchange docking connector 400 has a top bar 412 having an elongated portion and a perpendicular side portion 413 extending from each end of the elongated portion. Each side portion 413 has a mounting member 416 adapted to engage with a mounting member on a second elongated bar 430. A removable bottom bar 420 is connected to the top bar 412 via screws 440 placed through thru-hole 442 in a mounting member 423 on the bottom bar 420 and thru-hole 418 in the top bar and secured in threaded holes 444. When connected the top bar and the bottom bar form a rectangular frame in which modules may be mounted. The elongated portion of the top bar 412 has on its side facing the interior of the docking connector frame has a plurality of horseshoe-shaped grooves 414 each for receiving an end of a module 350. The bottom bar 420 has a groove along is length facing the interior of the frame for receiving a second end of each module. Once modules are placed into the docking connector frame, a retaining bar 430 is secured to the top bar 412 to hold the modules 350 in place. The retaining bar 430 is secured to the top bar 412 via screws 450 placed through thru-holes 432 and into threaded holes 411. Contact pins (not shown) can be placed in the modules and patchcords (not shown) can be connected to the pins.

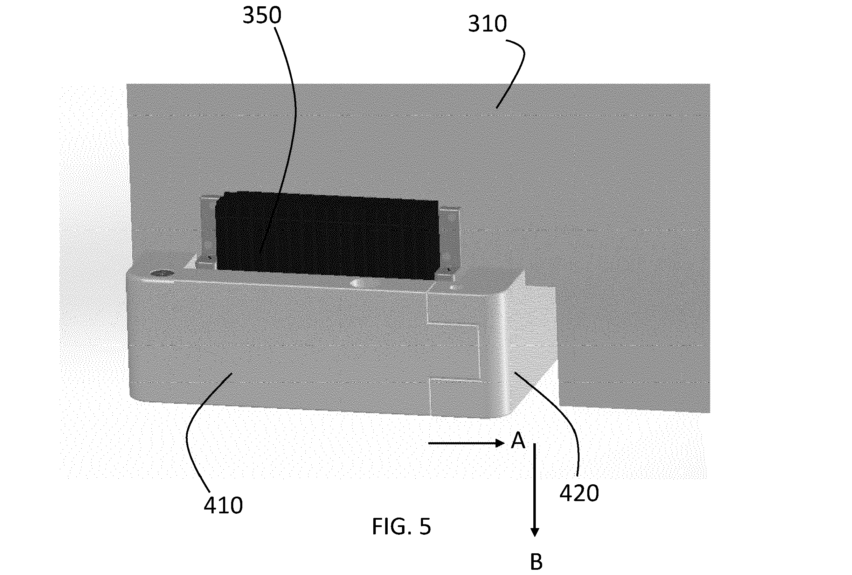

As shown in FIG. 5, to remove the PCB's through the front of the test adapter 220, the two screws 440 are removed from the docking connector thereby freeing the bottom bar 420 to be moved in Direction A away from the top bar and then in direction B to be removed altogether. If the screws securing the modules 222 o the test adapter 220 are removed (either before or after removing the bottom bar o the docking connector, once the bottom bar 420 is removed the PCB's can slide directly out of the front of the test adapter.

This quick exchange docking connector design provides for each removal of the PCB's from a fixture or enclosure for replacing, repairing, or otherwise servicing the PCB's.

The foregoing description of the preferred embodiment of the invention has been presented for purposes of illustration and description. It is not intended to be exhaustive or to limit the invention to the precise form disclosed, and modifications and variations are possible in light of the above teachings or may be acquired from practice of the invention, provided that said modifications and variations fall within the scope of the appended claims. The embodiment was chosen and described in order to explain the principles of the invention and its practical application to enable one skilled in the art to utilize the invention in various embodiments as are suited to the particular use contemplated. It is intended that the scope of the invention be defined by the claims appended hereto.

## Claims

1. A docking connector (400) comprising:
a first frame portion (410) comprising:
a first elongated bar (412) having a first end, a second end, and a plurality of grooves (414) perpendicular to and spaced along a length said first elongated bar (412), each said groove (414) being configured to receive an end of a module (350) spaced along the length of the first elongated bar;
a first side bar (413) extending from said first end of the first elongated bar (412) perpendicular to said first elongated bar; and
a second side bar (413) extending from said second end of the first elongated bar perpendicular to said first elongated bar
wherein said first and second side bars (413) each have at an end away from said
first elongated bar a first mounting member (416); and
a second frame portion (420) comprising a second elongated bar (422) having a first end and a second end and a second mounting member (423) at each of first and second ends, said second elongated bar (422) having a plurality of grooves perpendicular to and spaced along a length said second elongated bar, each groove being configured to receive an end of said module (350) connected to said first elongated bar (412);
wherein said second frame portion (420) is removably secured to said first frame portion (410) by connecting said first mounting member (416) of said first side bar (413) to said second mounting member (423) on said first end of said second elongated bar (422) and connecting said first mounting member (416) on said second side bar (413) to said second mounting member (423) on said second end of said second elongated bar (422) to form a frame (400) having two pairs of opposing sides with said spaced grooves (414) on said first elongated bar and said grooves on said second elongated bar (422) facing an interior of said frame;
said first mounting member (416) on each of said first and second side bars (413) is a tab having a thru-hole (418);
**characterized in that**
said second mounting member (423) at each end of said second elongated bar (422) is a pair of spaced tabs, wherein one tab of the pair of spaced tabs comprises a thru-hole (442) and the other tab of the pair of spaced tabs comprises threaded hole (444);
wherein said second frame portion (420) is removably secured to said first frame portion (410) via screws (440) with the tab of said first mounting member (416) of said first side bar (413) secured between one pair of said spaced tabs of said second mounting member (423) on said first end of said second elongated bar (422) and with the tab of said first mounting member (416) on said second side bar (413) secured between a second pair of spaced tabs of said second mounting member (423) on said second end of said second elongated bar (422), to form said frame (400),
wherein the screws (440) are placed through the thru-hole (442) in said second mounting member (423) on the second elongated bar (422) and the thru-hole (418) in the first mounting member (416) and secured in the threaded holes (444);
wherein the docking connector (400) comprises:
a module (350) having a first end in one of said grooves (414) in said first elongated bar (412) and a second end in said groove in said second elongated bar (422); and
a retaining bar (430) secured to said first elongated bar (410) to hold said module (350) in said groove (414) in said first elongated bar (412).

2. A docking connector according to claim 1 wherein said retaining bar is secured to said first elongated bar (410) with screws (450).

3. A docking connector according to claim 1 or 2 further comprising:
a plurality of contact pins mounted in said module (350).

## Patentansprüche

1. Andockverbinder (400), umfassend:
einen ersten Rahmenabschnitt (410), umfassend:
eine erste längliche Stange (412) mit einem ersten Ende, einem zweiten Ende und einer Vielzahl von Nuten (414) senkrecht zu und beabstandet entlang einer Länge der ersten länglichen Stange (412), wobei jede Nut (414) eingerichtet ist, um ein Ende eines entlang der Länge der ersten länglichen Stange beabstandeten Moduls (350) aufzunehmen;
eine erste Seitenstange (413), sich von dem ersten Ende der ersten länglichen Stange (412) senkrecht zu der ersten länglichen Stange erstreckend; und
eine zweite Seitenstange (413), sich von dem zweiten Ende der ersten länglichen Stange senkrecht zu der ersten länglichen Stange erstreckend,
die erste und die zweite Seitenstange (413) jeweils an einem von der ersten länglichen Stange entfernten Ende ein erstes Befestigungselement (416) aufweisend; und
einen zweiten Rahmenabschnitt (420), umfassend eine zweite längliche Stange (422) mit einem ersten Ende und einem zweiten Ende und ein zweites Befestigungselement (423) an jedem von dem ersten und dem zweiten Ende, die zweite längliche Stange (422) aufweisend eine Vielzahl von Nuten senkrecht zu und beabstandet entlang einer Länge der zweiten länglichen Stange, wobei jede Nut eingerichtet ist, um ein mit der ersten länglichen Stange (412) verbundenes Ende des Moduls (350) aufzunehmen;
wobei der zweite Rahmenabschnitt (420) entfernbar an dem ersten Rahmenabschnitt (410) befestigt ist, indem das erste Befestigungselement (416) der ersten Seitenstange (413) mit dem zweiten Befestigungselement (423) an dem ersten Ende der zweiten länglichen Stange (422) verbunden wird und das erste Befestigungselement (416) an der zweiten Seitenstange (413) mit dem zweiten Befestigungselement (423) an dem zweiten Ende der zweiten länglichen Stange (422) verbunden wird, um einen Rahmen (400) mit zwei Paaren gegenüberliegender Seiten zu bilden, wobei die beabstandeten Nuten (414) an der ersten länglichen Stange und die Nuten an der zweiten länglichen Stange (422) einem Inneren des Rahmens zugewandt sind;
das erste Befestigungselement (416) an jeder von der ersten und der zweiten Seitenstange (413) eine Lasche mit einem Durchgangsloch (418) ist;
**dadurch gekennzeichnet, dass**
das zweite Befestigungselement (423) an jedem Ende der zweiten länglichen Stange (422) ein Paar beabstandeter Laschen ist, eine Lasche des Paars beabstandeter Laschen umfassend ein Durchgangsloch (442) und die andere Lasche des Paars beabstandeter Laschen umfassend ein Gewindeloch (444);
wobei der zweite Rahmenabschnitt (420) entfernbar an dem ersten Rahmenabschnitt (410) über Schrauben (440) befestigt ist, wobei die Lasche des ersten Befestigungselements (416) der ersten Seitenstange (413) zwischen einem Paar der beabstandeten Laschen des zweiten Befestigungselements (423) an dem ersten Ende der zweiten länglichen Stange (422) befestigt ist und wobei die Lasche des ersten Befestigungselements (416) an der zweiten Seitenstange (413) zwischen einem zweiten Paar beabstandeter Laschen des zweiten Befestigungselements (423) an dem zweiten Ende der zweiten länglichen Stange (422) befestigt ist, um den Rahmen (400) zu bilden,
wobei die Schrauben (440) durch das Durchgangsloch (442) in dem zweiten Befestigungselement (423) an der zweiten länglichen Stange (422) und das Durchgangsloch (418) in dem ersten Befestigungselement (416) platziert und in den Gewindelöchern (444) befestigt sind;
der Andockverbinder (400) umfassend:
ein Modul (350) mit einem ersten Ende in einer der Nuten (414) in der ersten länglichen Stange (412) und einem zweiten Ende in der Nut in der zweiten länglichen Stange (422); und
eine Haltestange (430), die an der ersten länglichen Stange (410) befestigt ist, um das Modul (350) in der Nut (414) in der ersten länglichen Stange (412) zu halten.

2. Andockverbinder nach Anspruch 1, wobei die Haltestange an der ersten länglichen Stange (410) mit Schrauben (450) befestigt ist.

3. Andockverbinder nach Anspruch 1 oder 2, ferner umfassend:
eine Vielzahl von in dem Modul (350) montierten Kontaktstiften.

## Revendications

1. Connecteur d'accueil (400) comprenant :
une première partie de cadre (410) comprenant :
une première barre allongée (412) ayant une première extrémité, une deuxième extrémité, et une pluralité de rainures (414) perpendiculaires à et espacées le long d'une longueur de ladite première barre allongée (412), chaque rainure (414) étant configurée pour recevoir une extrémité d'un module (350) espacé le long de la longueur de la première barre allongée ;
une première barre latérale (413) s'étendant à partir de ladite première extrémité de la première barre allongée (412) perpendiculairement à ladite première barre allongée ; et
une deuxième barre latérale (413) s'étendant à partir de ladite deuxième extrémité de la première barre allongée perpendiculairement à ladite première barre allongée,
lesdites première et deuxième barres latérales (413) ayant chacune, au niveau d'une extrémité éloignée de ladite première barre allongée, un premier élément de montage (416) ; et
une deuxième partie de cadre (420) comprenant une deuxième barre allongée (422) ayant une première extrémité et une deuxième extrémité et un deuxième élément de montage (423) au niveau de chacune des première et deuxième extrémités, ladite deuxième barre allongée (422) ayant une pluralité de rainures perpendiculaires à et espacées le long d'une longueur de ladite deuxième barre allongée, chaque rainure étant configurée pour recevoir une extrémité dudit module (350) connecté à ladite première barre allongée (412) ;
ladite deuxième partie de cadre (420) étant fixée de manière amovible à ladite première partie de cadre (410) en connectant ledit premier élément de montage (416) de ladite première barre latérale (413) audit deuxième élément de montage (423) sur ladite première extrémité de ladite deuxième barre allongée (422) et en connectant ledit premier élément de montage (416) sur ladite deuxième barre latérale (413) audit deuxième élément de montage (423) sur ladite deuxième extrémité de ladite deuxième barre allongée (422) pour former un cadre (400) ayant deux paires de côtés opposés avec lesdites rainures espacées (414) sur ladite première barre allongée et lesdites rainures sur ladite deuxième barre allongée (422) faisant face à un intérieur dudit cadre ;
ledit premier élément de montage (416) sur chacune desdites première et deuxième barres latérales (413) étant une languette ayant un trou traversant (418) ;
**caractérisé en ce que**
ledit deuxième élément de montage (423) au niveau de chaque extrémité de ladite deuxième barre allongée (422) est une paire de languettes espacées, une languette de la paire de languettes espacées comprenant un trou traversant (442) et l'autre languette de la paire de languettes espacées comprenant un trou fileté (444) ;
ladite deuxième partie de cadre (420) étant fixée de manière amovible à ladite première partie de cadre (410) par l'intermédiaire de vis (440) avec la languette dudit premier élément de montage (416) de ladite première barre latérale (413) fixée entre une paire desdites languettes espacées dudit deuxième élément de montage (423) sur ladite première extrémité de ladite deuxième barre allongée (422) et avec la languette dudit premier élément de montage (416) sur ladite deuxième barre latérale (413) fixée entre une deuxième paire de languettes espacées dudit deuxième élément de montage (423) sur ladite deuxième extrémité de ladite deuxième barre allongée (422), pour former ledit cadre (400),
les vis (440) étant placées à travers le trou traversant (442) dans ledit deuxième élément de montage (423) sur la deuxième barre allongée (422) et le trou traversant (418) dans le premier élément de montage (416) et fixées dans les trous filetés (444) ;
le connecteur d'accueil (400) comprenant :
un module (350) ayant une première extrémité dans l'une desdites rainures (414) dans ladite première barre allongée (412) et une deuxième extrémité dans ladite rainure dans ladite deuxième barre allongée (422) ; et
une barre de retenue (430) fixée à ladite première barre allongée (410) pour maintenir ledit module (350) dans ladite rainure (414) dans ladite première barre allongée (412).

2. Connecteur d'accueil selon la revendication 1, ladite barre de retenue étant fixée à ladite première barre allongée (410) avec des vis (450).

3. Connecteur d'accueil selon la revendication 1 ou 2, comprenant en outre :
une pluralité de broches de contact montées dans ledit module (350).
